(19) Europäisches Patentamt
European Patent Office
Office européen des brevets

(11) **EP 2 421 152 A1**

(12) **EUROPEAN PATENT APPLICATION**
published in accordance with Art. 153(4) EPC

(43) Date of publication:
**22.02.2012 Bulletin 2012/08**

(21) Application number: **10764303.3**

(22) Date of filing: **03.02.2010**

(51) Int Cl.:
**H03H 11/04** (2006.01)  **H03H 7/12** (2006.01)
**H03H 11/20** (2006.01)

(86) International application number:
**PCT/JP2010/051477**

(87) International publication number:
**WO 2010/119717 (21.10.2010 Gazette 2010/42)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **15.04.2009 JP 2009098847**

(71) Applicant: **Marcdevices Co., Ltd.**
**Kanagawa 254-0811 (JP)**

(72) Inventor: **HIRAMA, Koichi**
**Hiratsuka-shi**
**Kanagawa 254-0811 (JP)**

(74) Representative: **Manitz, Finsterwald & Partner GbR**
**Martin-Greif-Strasse 1**
**80336 München (DE)**

(54) **FREQUENCY-VARYING COMPLEX RESONANT CIRCUIT**

(57)     A composite resonance circuit is provided of which the resonance frequency range can be set with greater degrees of freedom with the peak frequency of the resonance characteristic curve of a resonance unit having good linearity and the resonance sharpness Q-factor being kept within a desired range. In the composite resonance circuit according to the present invention, first and second relay circuits are respectively connected between the resonance unit and first and second phase shift circuits that shift an input frequency signal by different phases. Hence, the resonance frequency range can be set by setting the gains and impedances of the first and second relay circuits according to its use, without changing resonance elements or the like of the resonance unit.

FIG. 8

**Description**

Technical Field

The present invention relates to a composite resonance circuit of which the resonance frequency is variable.

Background Art

In connection with electronic components using a natural resonance frequency such as piezoelectric vibrators, a method where a reactance element such as a capacitor is serially connected is well known as means for changing their zero-phase frequency, that is, the resonance frequency, but their frequency range itself cannot be changed by changing a physical constant of the piezoelectric vibrator or the like. Thus, there is a drawback that when the frequency is changed over a wide variable range, the output itself is reduced.

For example, patent literature 1 discloses an RC polyphase filer comprising four input terminals for receiving four-phase signals having a phase difference of 90° and a circuit for outputting four-phase signals. In this filer, a quasi-resonant peak voltage is generated under non-zero reactance of resistors, capacitors, and the like, that is, using an element having no resonance frequency, but the frequency range itself cannot be changed.

Meanwhile, as to piezoelectric transducers of the conventional art, a method is widely known in which in order to make them function over a desired wide frequency range, their resonance sharpness Q-factor is degraded to a necessary value, but there is the defect that they are easily affected by external noise power. Further, there is a method where by arranging a plurality of piezoelectric transducers different in frequency, a wide frequency band is produced without the resonance sharpness Q-factor being degraded, but the method has the defect that the positions of their radiation beams cannot be made to coincide, and that the total size of the piezoelectric transducers is large, resulting in being difficult to miniaturize.

In summary, with conventional composite resonance circuits, the width of the resonance frequency variable range cannot be set unless, e.g., the physical constant of a resonance element comprising a coil and a capacitor is changed.

Patent Literature 1: Japanese Patent Kokai No. 2006-319115

Disclosure of the Invention

[Problem to be solved by the invention]

An object of the present invention is to provide a composite resonance circuit which enables the resonance frequency variable range to be set with greater degrees of freedom so as to cover a wide frequency range without changing the physical constant of a resonance element comprising coils, capacitors, and the like and without degrading the effective resonance sharpness Q-factor.

[Means for solving the problem]

A composite resonance circuit according to the present invention comprises an input terminal; a resonance unit having first and second input ports; and first and second phase shift circuits that perform different phase shifts on an input signal.supplied to the input terminal and supply the phase-shifted signals respectively to the first and second input ports of the resonance unit. First and second relay circuits are respectively connected between the first phase shift circuit and the first input port and between the second phase shift circuit and the second input port to relay shift outputs of the first and second phase shift circuits to the resonance unit.

With this composite resonance circuit, the resonance frequency variable range can be set with greater degrees of freedom so as to cover a wide frequency range, without changing the physical constant of the resonance element consisting of coils, capacitors, and the like and without degrading the effective resonance sharpness Q-factor. For example, the composite resonance circuit may be designed to have selected relay circuits having optimum gains and impedances such that the output of the resonance unit has a resonance frequency range, resonance sharpness, and the like depending on its use, from among several kinds of first and second relay circuits that are built in beforehand for characteristics (e.g., the resonance frequency range, resonance sharpness, etc.) of a combined circuit of the first and second phase shift circuits and the resonance unit.

Brief Description of Drawings

FIG. 1 is a circuit diagram of a composite resonance circuit of a first embodiment of the present invention;
FIG. 2 is a circuit diagram of an internal resistance variable drive circuit of the composite resonance circuit of FIG. 1;
FIG. 3 shows relationships between internal resistance and output voltage and the transmissibility of a variable attenuator;
FIG. 4 is a circuit diagram of a composite resonance circuit of a second embodiment of the present invention;
FIG. 5 is a conceptual, illustrative diagram of a compensation function;
FIG. 6 shows an example frequency characteristic before compensation;
FIG. 7 shows an example frequency characteristic after compensation; and
FIG. 8 is a circuit diagram of a composite resonance circuit of a third embodiment of the present invention.

<Explanation of Reference Numerals>

1 Composite resonance circuit
2 Reference terminal
3 Input terminal
SG Standard signal generator
f Frequency output from standard signal generator SG
4 First phase control circuit
5 Second phase control circuit
6 Resonance circuit
7 First relay circuit
8 Second relay circuit
11 First internal resistance variable drive circuit
12 Second internal resistance variable drive circuit
13 Negative feedback amplifier
14 Input-side adder circuit
15 Output-side adder circuit
17 Function transformer group
22 First output adjustment circuit
23 Second output adjustment circuit
34 Function transformer group

Detailed Description of the Invention

Embodiment 1

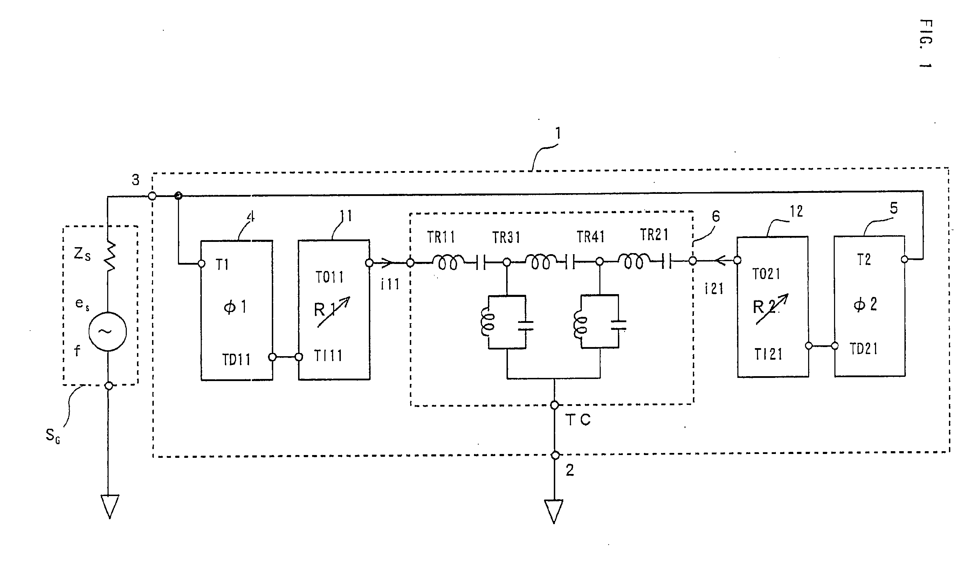

FIG. 1 shows Embodiment 1 according to a composite resonance circuit of the present invention. As shown in FIG. 1, a composite resonance circuit 1 comprises an input terminal 3, a resonance circuit 6 having a first port terminal TR11 and a second port terminal TR21, and first and second phase control circuits 4 and 5 performing different phase shifts $\phi1$ and $\phi2$ on an input signal of a frequency f supplied to the input terminal 3 to supply the phase-shifted signals respectively to the first port terminal TR11 and the second port terminal TR21 of the resonance circuit 6. First and second relay circuits 11, 12 are connected respectively between the first phase control circuit 4 and the first port terminal TR11 and between the second phase control circuit 5 and the second port terminal TR21 to relay the shifted signal outputs of the first and second phase control circuits 4 and 5 to the resonance unit. Note that in Embodiment 1 the first and second relay circuits 11, 12 are embodied as first and second internal resistance variable drive circuits 11, 12. The respective output impedances of the first and second internal resistance variable drive circuits 11, 12 are variable independently of each other. The output impedances are variable according to control signals independently of each other.
The components of the composite resonance circuit 1 shown in FIG. 1 will be further described in detail. The input terminal 3 of the composite resonance circuit 1 of FIG. 1 is connected to a standard signal generator SG, and an input signal having its output power maintained constant and its frequency f swept continuously is applied to the input terminal 3 of the composite resonance circuit 1. The input signal is supplied to each of an input terminal T1 of the first phase control circuit 4 and an input terminal T2 of the second phase control circuit 5.

The first phase control circuit 4 has the input terminal T1 and a phase control output terminal TD11. The input terminal T1 is connected to the input terminal 3, and the phase control output terminal TD11 is connected to an input terminal TI11 of the first internal resistance variable drive circuit 11. The first phase control circuit 4 has the input signal inputted thereto via the input terminal T1 and shifts the phase of the input signal applied to the input terminal T1 by $\phi1$. Further, the first phase control circuit 4 outputs the signal having its phase shifted by $\phi1$ via the phase control output terminal TD11 to the input terminal TI11 of the first internal resistance variable drive circuit 11.

The second phase control circuit 5 has the input terminal T2 and a phase control output terminal TD21. The input terminal T2 is connected to the input terminal 3, and the phase control output terminal TD21 is connected to an input terminal TI21 of the second internal resistance variable drive circuit 12. The second phase control circuit 5 has the input signal inputted thereto via the input terminal T2 and shifts the phase of the input signal applied to the input terminal T2 by $\phi2$. Further, the second phase control circuit 5 outputs the signal having its phase shifted by $\phi2$ via the phase control output terminal TD21 to the input terminal TI21 of the second internal resistance variable drive circuit 12

Note that the phase difference between the phase control output terminal TD11 of the first phase control circuit 4 and the phase control output terminal TD21 of the second phase control circuit 5 is $(\phi2 - \phi1)$.

In variants of the first and second phase control circuits 4, 5, the phases $\phi1$ and $\phi2$ by which the first and second phase control circuits 4, 5 shift respectively are variable continuously or stepwise manually as well as having preset, fixed values. Further, as described in Embodiments 2 and 3, the phases $\phi1$ and $\phi2$ are variable continuously or stepwise according to phase control signals.

The first internal resistance variable drive circuit 11 has the input terminal TI11 and a drive output terminal TO11. The input terminal TI11 is connected to the phase control output terminal TD11 of the first phase control circuit 4, and the drive output terminal TO11 is connected to the first port terminal TR11 of the resonance circuit 6. The signal having its phase shifted by $\phi1$ is input to the first internal resistance variable drive circuit 11 via the input terminal TI11. Further, the first internal resistance variable drive circuit 11 adjusts its own output impedance according to an impedance control signal and outputs the signal having its phase shifted by $\phi1$ with its output power maintained via the drive output terminal TO11 to the first port terminal TR11 of the resonance circuit 6.

The second internal resistance variable drive circuit 12 has the input terminal TI21 and a drive output terminal T021. The input terminal TI21 is connected to the phase control output terminal TD21 of the second phase control circuit 5, and the drive output terminal T021 is connected to the second port terminal TR21 of the resonance circuit 6. The signal having its phase shifted by $\phi2$ is input to the second internal resistance variable drive circuit 12 via the input terminal TI21. Further, the second internal resistance variable drive circuit 12 adjusts its own output impedance according to an impedance control signal and outputs the signal having its phase shifted by $\phi2$ with its output power maintained via the drive output terminal T021 to the second port terminal TR21 of the resonance circuit 6.

In variants of the first and second internal resistance variable drive circuits 11, 12, the output impedance of the first internal resistance variable drive circuit 11 is variable continuously or stepwise manually as well as having a preset, fixed value. Further, as described in Embodiments 2 and 3, the phases $\phi1$ and $\phi2$ are variable continuously or stepwise according to phase control signals.

Note that the difference in phase between the input signal at the drive output terminal TO11 of the first internal resistance variable drive circuit 11 and the input signal at the drive output terminal T021 of the first internal resistance variable drive circuit 11 is $(\phi2 - \phi1)$. Hereinafter this phase difference is referred to as a control phase quantity $(\phi2 - \phi1)$. Internal voltages e1 and e2 of the drive circuits as viewed respectively from the drive output terminal TO11 of the first internal resistance variable drive circuit 11 and from the drive output terminal T021 of the second internal resistance variable drive circuit 12 are variable continuously or stepwise within a desired range without extremely fluctuating, and are varied by the values of their internal resistances R1 and R2, that is, the values of an internal resistance control quantity TRCP11 and the like varying according to impedance control signals.

Next, the resonance circuit 6 will be described. The resonance circuit 6 has the first and second port terminals TR11 and TR21, and a common terminal TC. The first and second port terminals TR11 and TR21 are connected respectively to the drive output terminal TO11 of the first internal resistance variable drive circuit 11 and the drive output terminal TO21 of the second internal resistance variable drive circuit 12. The common terminal TC is connected to a reference terminal 2. The resonance circuit 6 has a first two-terminal circuit Z1' connected between terminal TR11 and terminal TR31, a second two-terminal circuit Z2' connected between terminal TR31 and the common terminal TC, a first two-terminal circuit Z3' connected between terminal TR31 and terminal TR41, a second two-terminal circuit Z4' connected between terminal TR41 and the common terminal TC, and a first two-terminal circuit Z5' connected between terminal TR41 and terminal TR21. The first two-terminal circuits Z1', Z3', Z5' are each a series circuit of a coil and a capacitor, and the second two-terminal circuits Z2', Z4' are each a parallel circuit of a coil and a capacitor. The immittance frequencies of these five resonant circuits are, for example, all set at 10,000 kHz. Table 1 shows the inductance value of the coil and the capacitance value of the capacitor of each of the five two-terminal circuits Z1', Z2', Z3', Z4', Z5'. Note that the resonance circuit 6 having the first and second port terminals TR11 and TR21 and the common terminal TC may take on any circuit form as long as it is a substantially reversible circuit.

[Table 1]

| | | Inductance (H) | | Capacitance (F) |
|---|---|---|---|---|
| Z1' | Ls1 | 0.017931454 | Cs1 | 1.41262E-14 |
| Z2' | Lp2 | 8.13507E-09 | Cp2 | 3.11372E-08 |
| Z3' | Ls3 | 0.005160886 | Cs3 | 4.90813E-14 |
| Z4' | Lp4 | 2.04245E-08 | Cp4 | 1.24019E-08 |
| Z5' | Ls5 | 0.001043762 | Cs5 | 2.42683E-13 |

The resonance circuit 6 is supplied via the first and second port terminals TR11 and TR21 with the signal having its phase shifted by $\phi 1$ and the signal having its phase shifted by $\phi 2$ with respect to the input signal from the standard signal generator SG, and thereby currents i11 and i21 flow. Thus, the resonance circuit 6 generates a resonance peak current corresponding to the currents i11 and i21. The resonance output thereof can be output from, e.g., the first and second port terminals TR11 and TR21 as output terminals.

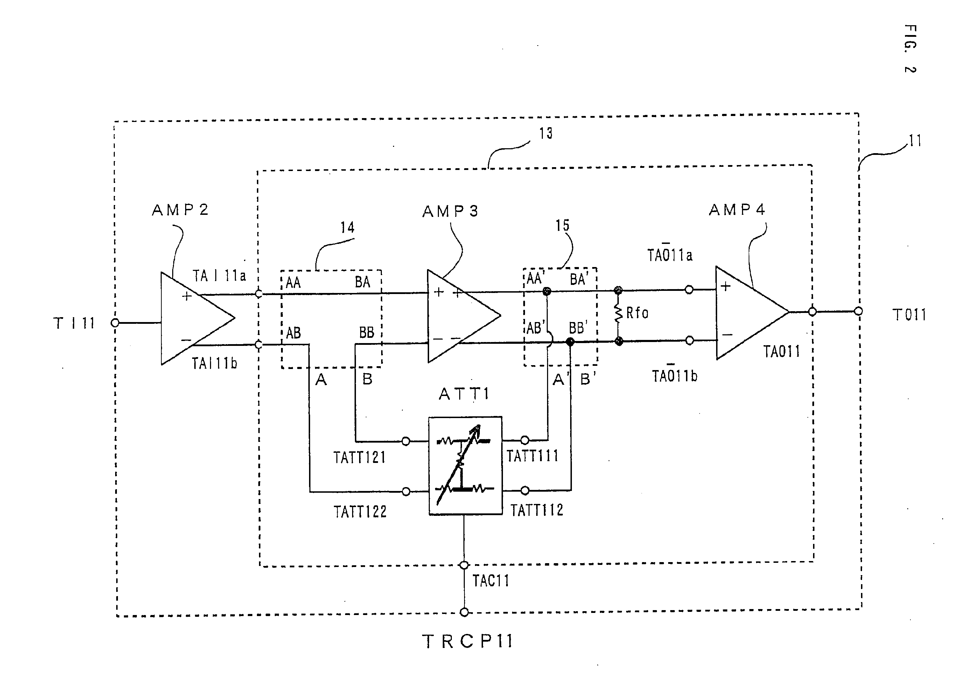

Next, the components of the two internal resistance variable drive circuits 11, 12 will be described in detail. Because the both circuits have the same function, only the former will be described using FIG. 2. The configuration thereof is as follows.

The internal resistance variable drive circuit 11 comprises the drive circuit input terminal TI11, the drive circuit output terminal TO11, an internal resistance control terminal TRCP11, a buffer amplifier AMP2 whose input terminal is connected to the drive circuit input terminal TI11, and a negative feedback amplifier 13 whose positive-phase input terminal TAI11a and reverse-phase input terminal TAI11b are respectively connected to a positive-phase output terminal and reverse-phase output terminal of the buffer amplifier AMP2. An output terminal TA011 of the negative feedback amplifier 13 is connected to the drive circuit output terminal TO11. An attenuation control terminal TAC11 of the negative feedback amplifier 13 is connected to the internal resistance control terminal TRCP11. Note that the quantity applied to the internal resistance control terminal TRCP11 is called an "internal resistance control quantity" and denoted by RCP. The negative feedback amplifier 13 has an input-side adder circuit 14 whose positive-phase input terminal AA and reverse-phase input terminal AB are respectively connected to a positive-phase input terminal TAI11a and reverse-phase input terminal TAI11b. The negative feedback amplifier 13 further has an amplifier AMP3 whose positive-phase input terminal and reverse-phase input terminal are respectively connected to a positive-phase output terminal BA and reverse-phase output terminal BB of the input-side adder circuit 14. The negative feedback amplifier 13 further has an output-side adder circuit 15 whose positive-phase input terminal AA' and reverse-phase input terminal AB' are respectively connected to a positive-phase output terminal and reverse-phase output terminal of the amplifier AMP3. The adding terminals A and B of the input-side adder circuit 14 are respectively connected to a reverse-phase output terminal TATT122 and a positive-phase output terminal TATT121. The negative feedback amplifier 13 further has a variable attenuator ATT1 whose positive-phase input terminal TATT111 and reverse-phase input terminal TATT112 are respectively connected to adding terminals A' and B' of the output-side adder circuit 15. The negative feedback amplifier 13 further has a differential amplifier AMP4 whose two input terminals TAO11a and TAO11b are respectively connected to a positive-phase output terminal BA' and reverse-phase output terminal BB' of the output-side adder circuit 15. The output TAO11 of the differential amplifier AMP4 is connected to the drive circuit output terminal TO11. The attenuation control terminal TAC11 of the variable attenuator ATT1 is connected to the internal resistance control terminal TRCP11. A resistor RfO may be connected between the two input terminals TAO11a and TAO11b as needed.

In the input-side adder circuit 14, the positive-phase input terminal AA and the positive-phase output terminal BA are connected, and the reverse-phase input terminal AB and the adding terminal A are connected, and the reverse-phase output terminal BB and the adding terminal B are connected. This input-side adder circuit 14 is **characterized in that** it is constituted by an analog serial adder circuit. In the output-side adder circuit 15, the positive-phase input terminal AA' and the reverse-phase input terminal AB' are respectively connected to the positive-phase output terminal BA' and the reverse-phase output terminal BB', and further the positive-phase input terminal AA' is connected to the adding terminal A', and the reverse-phase input terminal AB' is connected to the adding terminal B'. This output-side adder circuit 15 is constituted by an analog parallel adder circuit.

The attenuation control terminal TAC11 of the variable attenuator ATT1 is also called the internal resistance control terminal and denoted by TRCP11. The variable attenuator ATT1 has an electronic variable resistive element, a resistor-array electronic switching element, or the like so as to include an attenuating mechanism of which the attenuation varies continuously or stepwise.

This circuit has the following function. The feedback quantity of the negative feedback amplifier 13 can be changed by changing the transmissibility H of the variable attenuator ATT1. This transmissibility H is variable according to the internal resistance control quantity RCP11 applied to the internal resistance control terminal TRCP11. As a result, the respective internal resistances R1 and R2 of the internal resistance variable drive circuits 11, 12 connected to the resonance circuit 6 in FIG. 1 are made to change, and the function to alleviate the fluctuation of the output power is realized.

In the output-side adder circuit 15, a parallel adder circuit or a serial adder circuit is selected and used depending on the desired wide range of internal resistance values. In the embodiment of FIG. 1, a parallel feedback circuit is used as the output-side adder circuit 15.

The operation principle is as follows. First, the well-known operation-related parameters of the negative feedback amplifier 13 are shown together below for convenience of description. Let zi be the input impedance of the inverting amplifier AMP3 forming part of the feedback amplifier 13, zo be the output impedance of the AMP3, and -A be the amplification of the AMP3. Further, let H be the feedback factor of the variable attenuator ATT1. Then, the output impedance zout of the negative feedback amplifier 13 is given by the following equation.

[Equation 1]

$$z_{out} = \frac{1}{1 + AH} z_o$$

The input impedance zin of the negative feedback amplifier 13 is expressed by the following equation.

[Equation 2]

$$z_{in} = \left(1 + AH\right) z_i$$

The amplification G of the negative feedback amplifier 13 is expressed by the following equation.

[Equation 3]

$$G = \frac{-A}{1 + AH}$$

The quantities on the left side of the expressions 1 to 3 all depend on the feedback factor H of the variable attenuator ATT1. This invention was made focusing attention on this fact. That is, this fact means that the output impedance of the negative feedback amplifier 13 can be made to change to take on a desired value by changing only the feedback factor H of the variable attenuator ATT1 with the other parameters being fixed.

The feedback factor H can be changed by changing the internal resistance control quantity RCP11 applied to the internal resistance control terminal TRCP11. Eventually, the output impedance zout of the negative feedback amplifier 13 can be changed by changing the internal resistance control quantity RCP11 applied to the internal resistance control terminal TRCP11.

Next, where the internal resistance control quantity RCP11 applied to the internal resistance control terminal TRCP11 is changed, the principle concerning the alleviation of the fluctuation of the overall amplification GT that is the voltage ratio between the drive circuit input terminal TI11 and the drive circuit control output terminal TO11 will be described.

This effect can be realized by ingeniously setting the relationship between the values of the output impedance zob of the buffer amplifier AMP2 and the input impedance zin of the negative feedback amplifier 13.

The output state of the buffer amplifier AMP2 is defined by the two of the internal voltage eout proportional to the input signal and the output impedance zob. Because the negative feedback amplifier 13 having the input impedance zin is connected to the buffer amplifier AMP2, a voltage Vi applied to the input terminal TAI11 of the negative feedback amplifier 13 is given by the following equation.

[Equation 4]

$$v_i = \frac{z_{in}}{z_{ob} + z_{in}} e_{out}$$

Substituting Expression 2 giving the input impedance zin of the negative feedback amplifier 13 and Expression 3 giving the amplification G into Expression 4 to rewrite, the overall amplification GT including that of the buffer amplifier AMP2 is given by the following equation.

[Equation 5]

$$\frac{v_{out}}{e_{out}} = \frac{-1}{\left(1 + \frac{z_{ob}}{z_i}\right)\frac{1}{A} + H}$$

Here, vout is the output voltage of the negative feedback amplifier 13, and eout is the internal voltage of the buffer amplifier AMP2. Thus, the vout is a voltage proportional to the voltage applied to the input terminal of the buffer amplifier AMP2. It can be seen that the quantity on the left side of Expression 5, that is, the voltage ratio between the drive circuit input terminal TI11 and the drive circuit control output terminal TO11 is determined by the magnitude relation between the feedback factor H of the variable attenuator ATT1 and the first term of the denominator on the right side of Expression 5. Note that the value of the first term of the denominator on the right side of Expression 5 does not depend on that of the feedback factor H and can be set before shipment.

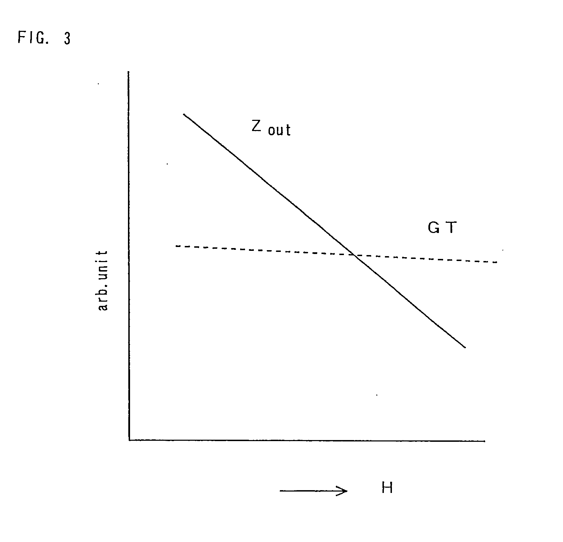

FIG. 3 shows conceptually changes in the internal resistance and the overall amplification of the internal resistance variable drive circuit of FIG. 2. The horizontal axis represents the transmissibility H of the variable attenuator ATT1. The vertical axis represents the internal resistance zout and the overall amplification GT in arbitrary units. The solid line indicates the internal resistance zout, and the dashed line indicates the overall amplification GT. The internal resistance zout indicated by the solid line can vary with the H on the horizontal axis over a wide range, and hence a desired value of the internal resistance zout can be obtained. The overall amplification GT indicated by the dashed line does not very much change with the H on the horizontal axis, and hence it is seen that the fluctuation of the amplification G associated with the negative feedback amplifier 13 is greatly reduced.

Although the above description has been made taking as an example a parallel feedback adder circuit as the output-side adder circuit 15 forming part of the negative feedback amplifier 13, the output-side adder circuit 15 may be embodied using a serial feedback adder circuit. In this case, the output impedance zout is given by the following equation.

[Equation 6]

$$z_{out} = \left(1 + AH\right)z_o$$

Comparing Expression 6 with Expression 1, it is found that their dependences on the fluctuation of the feedback quantity H are opposite to each other. Hence, a wide range of output impedances zout can be obtained depending on whether to use a serial feedback circuit or a parallel feedback circuit. Hence, a desired range of internal resistances zout, that is, internal resistances zout having a median value and a variable range width according to the feedback factor H can be obtained.

The operation of the composite resonance circuit of Embodiment 1 will be described. First, the input signal of a frequency f is applied to the input terminal 3. The first and second phase control circuits 4, 5 shift the phase of the input signal by $\phi 1$ and $\phi 2$ respectively. The first and second internal resistance variable drive circuits 11, 12 adjust their own output impedances according to impedance control signals applied to their internal resistance control terminals TRCP11 and output the signals having their phases shifted by $\phi 1$ and $\phi 2$ from the first and second phase control circuits 4, 5 to the resonance circuit 6. Thus, the signals having their phases shifted by $\phi 1$ and $\phi 2$ with respect to the input signal are supplied to the resonance circuit 6. The resonance circuit 6 can output a resonance output depending on the control phase quantity ($\phi 2 - \phi 1$) and the output impedances of the first and second internal resistance variable drive circuits 11, 12.

With the composite resonance circuit of Embodiment 1, the control phase quantity ($\phi 2 - \phi 1$) can be changed, and the first and second internal resistance variable drive circuits 11, 12 can be set to have optimum impedances so that the output of the resonance circuit 6 has a resonance frequency range, resonance sharpness, and the like depending on its use without changing the physical constants such as immittance frequencies of the five resonance elements in the resonance circuit 6.

Further, with the composite resonance circuit of Embodiment 1, because the output impedances of the first and second relay circuits 11, 12 are variable according to the impedance control signals, the resonance frequency range of the resonance circuit 6 can be finely adjusted.

Although in Embodiment 1 description has been made in which the output impedances of the first and second internal resistance variable drive circuits 11, 12 as the first and second relay circuits are variable according to the impedance control signals, as long as the impedances can be set to be optimal, they need not be variable. Namely, the first and second relay circuits of Embodiment 1 may be relay circuits having fixed gains and output impedances, or relay circuits whose gains and output impedances are adjustable manually independently of each other as long as the composite resonance circuit of the embodiment has a frequency range and resonance sharpness corresponding to its use.

Embodiment 2

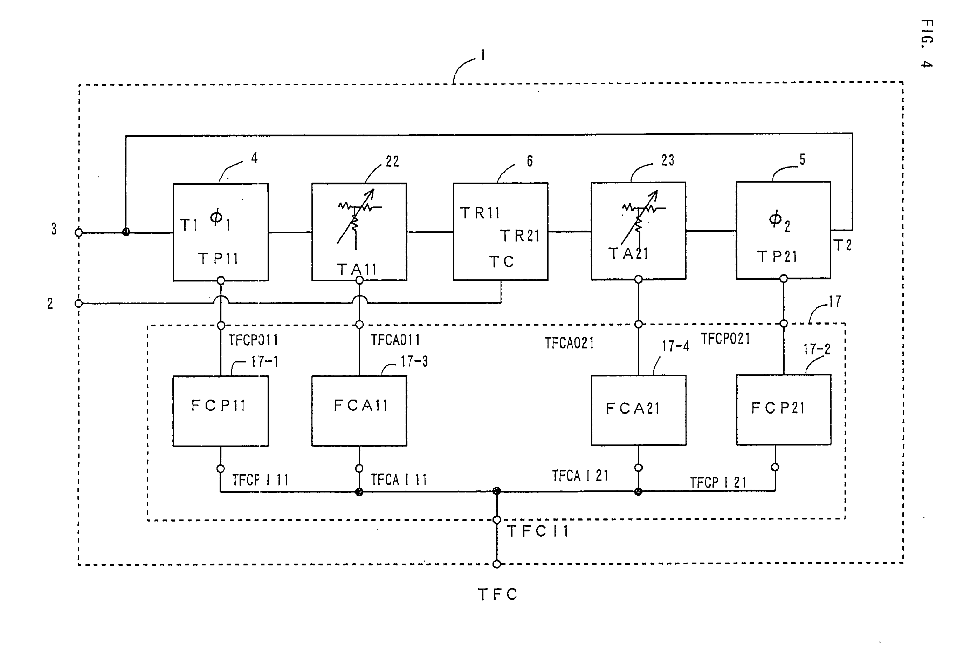

FIG. 4 shows Embodiment 2 according to a composite resonance circuit of the present invention. As shown in FIG. 4, a composite resonance circuit 1 comprises an input terminal 3, a resonance circuit 6 having a first port terminal TR11 and a second port terminal TR21, and first and second phase control circuits 4 and 5 performing different phase shifts $\phi 1$ and $\phi 2$ on an input signal supplied to the input terminal 3 to supply the phase-shifted signals to the first port terminal TR11 and the second port terminal TR21 of the resonance circuit 6 respectively. First and second relay circuits 22, 23 are connected respectively between the first phase control circuit 4 and the first port terminal TR11 and between the second phase control circuit 5 and the second port terminal TR21 to relay the shifted signal outputs of the first and second phase control circuits 4 and 5 to the resonance unit. Note that in Embodiment 2 the first and second relay circuits 22, 23 are embodied as first and second output adjustment circuits 22, 23. The respective gains of the first and second output adjustment circuits 22, 23 are variable independently of each other. The gains are variable according to control signals independently of each other.

The components of the composite resonance circuit 1 shown in FIG. 4 will be further described in detail. The input terminal 3 of the composite resonance circuit 1 of FIG. 4 is connected to the same standard signal generator SG (not shown) as in FIG. 1, and an input signal having its output power maintained constant and its frequency f swept continuously is applied to the input terminal of the composite resonance circuit 1. The input signal is supplied to each of an input terminal T1 of the first phase control circuit 4 and an input terminal T2 of the second phase control circuit 5.

The first phase control circuit 4 has the input terminal T1, a phase control signal input terminal TP11, and an output terminal. The input terminal T1 is connected to the input terminal 3; the output terminal is connected to an input terminal of the first output adjustment circuit 22; and the phase control signal input terminal TP11 is connected to a phase control signal output terminal TFCPO11 of a function transformer 17-1 of a function transformer group 17.

The first phase control circuit 4 has the input signal inputted thereto via the input terminal T1 and has a phase control signal from the function transformer 17-1 of the function transformer group 17 inputted thereto via the phase control signal input terminal TP11. Further, the first phase control circuit 4, in response to the phase control signal from the function transformer 17-1 of the function transformer group 17, shifts the phase of the input signal applied to the input terminal T1 by $\phi 1$. Further, the first phase control circuit 4 outputs the signal having its phase shifted by $\phi 1$ via the output terminal to the first output adjustment circuit 22.

The second phase control circuit 5 has the input terminal T2, a phase control signal input terminal TP21, and an output terminal. The input terminal T2 is connected to the input terminal 3; the output terminal is connected to an input terminal of the second output adjustment circuit 23; and the phase control signal input terminal TP21 is connected to a phase control signal output terminal TFCPO21 of a function transformer 17-2 of the function transformer group 17.

The second phase control circuit 5 has the input signal inputted thereto via the input terminal T2 and has a phase control signal from the function transformer 17-2 of the function transformer group 17 inputted thereto via the phase control signal input terminal TP21. Further, the second phase control circuit 5, in response to the phase control signal from the function transformer 17-2 of the function transformer group 17, shifts the phase of the input signal applied to the input terminal T2 by $\phi 2$. Further, the second phase control circuit 5 outputs the signal having its phase shifted by $\phi 2$ via the output terminal to the second output adjustment circuit 23.

In variants of the first and second phase control circuits 4, 5, the phases $\phi 1$ and $\phi 2$ by which the first and second phase control circuits 4, 5 shift respectively may be variable continuously or stepwise according to control signals, or variable continuously or stepwise manually having preset, fixed values.

The first output adjustment circuit 22 has an input terminal, a first output adjustment signal input terminal TA11, and an output terminal. The input terminal of the first output adjustment circuit 22 is connected to the output terminal of the first phase control circuit 4. The output terminal of the first output adjustment circuit 22 is connected to the first port TR11 of the resonance circuit 6. The first output adjustment signal input terminal TA11 is connected to a phase control signal output terminal TFCAO11 of a function transformer 17-3 of the function transformer group 17.

The signal having its phase shifted by $\phi 1$ is input to the first output adjustment circuit 22 via its input terminal. Further, a gain control signal from the function transformer 17-3 of the function transformer group 17 is input to the first output adjustment circuit 22 via the first output adjustment signal input terminal TA11. Further, the first output adjustment circuit 22, in response to the gain control signal from the function transformer 17-3 of the function transformer group 17, adjusts its own gain, thereby adjusting the output power of the signal having its phase shifted by $\phi 1$ and outputs the signal having its phase shifted by $\phi 1$ with its output power adjusted via the output terminal to the first port TR11 of the resonance circuit 6.

The second output adjustment circuit 23 has an input terminal, a second output adjustment signal input terminal TA21, and an output terminal. The input terminal of the second output adjustment circuit 23 is connected to the output terminal of the second phase control circuit 5. The output terminal of the second output adjustment circuit 23 is connected to the second port TR21 of the resonance circuit 6. The second output adjustment signal input terminal TA21 is connected to a phase control signal output terminal TFCA021 of a function transformer 17-4 of the function transformer group 17.

The signal having its phase shifted by $\phi 2$ is input to the second output adjustment circuit 23 via its input terminal. Further, a gain control signal from the function transformer 17-4 of the function transformer group 17 is input to the second output adjustment circuit 23 via the second output adjustment signal input terminal TA21. Further, the second output adjustment circuit 23, in response to the gain control signal from the function transformer 17-4 of the function transformer group 17, adjusts its own gain, thereby adjusting the output power of the signal having its phase shifted by $\phi 2$ and outputs the signal having its phase shifted by $\phi 2$ with its output power adjusted via the output terminal to the second port TR21 of the resonance circuit 6.

In variants of the first and second output adjustment circuits 22, 23, the gain of the first and second output adjustment circuit 22, 23 may be variable continuously or stepwise according to the gain control signal, or may have a preset, fixed value, or may be variable continuously or stepwise manually.

Next, the resonance circuit 6 will be described. The resonance circuit 6 has the first and second port terminals TR11 and TR21, and a common terminal TC. The first and second port terminals TR11 and TR21 are connected respectively to the output terminal of the first output adjustment circuit 22 and the output terminal of the second output adjustment circuit 23. The common terminal TC is connected to a reference terminal 2. The signal having its phase shifted by $\phi 1$ with its output power adjusted is input thereto via the first port TR11, and the signal having its phase shifted by $\phi 2$ with its output power adjusted is input thereto via the second port TR21. The circuit configuration of the resonance circuit 6 of FIG. 4 is the same as in, e.g., FIG. 1, and hence detailed description thereof is omitted.

Next, the function transformer group 17 will be described. The function transformer group 17 has the function transformers 17-1, 17-2, 17-3, 17-4, and a phase control signal input terminal TFCI1. The function transformers 17-1 and 17-2 generate the phase control signals according to a frequency control signal, and the function transformers 17-3 and 17-4 generate the gain control signals according to the frequency control signal.

The function transformer 17-1 has an input terminal TFCPI11 and an output terminal TFCPO11. The input terminal TFCPI11 is connected to the phase control signal input terminal TFCI1 of the function transformer group 17, and the output terminal TFCPO11 is connected to the TP11 of the first phase control circuit 4. The function transformer 17-1 has the frequency control signal inputted thereto via the input terminal TFCPI11 and generates a phase control signal according to the frequency control signal and outputs the generated phase control signal via the output terminal TFCPO11 to the phase control signal input terminal TP11 of the first phase control circuit 4.

The function transformer 17-2 has an input terminal TFCPI21 and an output terminal TFCP021. The input terminal TFCPI21 is connected to the phase control signal input terminal TFCI1 of the function transformer group 17, and the output terminal TFCPO21 is connected to the TP21 of the second phase control circuit 5. The function transformer 17-2 has the frequency control signal inputted thereto via the input terminal TFCPI21 and generates a phase control signal according to the frequency control signal and outputs the generated phase control signal via the output terminal TFCPOO21 to the phase control signal input terminal TP21 of the second phase control circuit 5.

The function transformer 17-3 has an input terminal TFCAI11 and an output terminal TFCAO11. The input terminal TFCAI11 is connected to the phase control signal input terminal TFCI1 of the function transformer group 17, and the output terminal TFCAO11 is connected to the TA11 of the first output adjustment circuit 22. The function transformer 17-3 has the frequency control signal inputted thereto via the input terminal TFCAI11 and generates a gain control signal according to the frequency control signal and outputs the generated gain control signal via the output terminal TFCAO11 to the TA11 of the first output adjustment circuit 22.

The function transformer 17-4 has an input terminal TFCAI21 and an output terminal TFCA021. The input terminal TFCAI21 is connected to the phase control signal input terminal TFCI1 of the function transformer group 17, and the output terminal TFCA021 is connected to the TA21 of the second output adjustment circuit 23. The function transformer 17-4 has the frequency control signal inputted thereto via the input terminal TFCAI21 and generates a gain control signal according to the frequency control signal and outputs the generated gain control signal via the output terminal TFCA021 to the TA21 of the second output adjustment circuit 23.

As to the two phase control signal input terminals TP11, TP21, a function relationship between the input and output terminals TFCPI11, TFCPO11 of the function generator 17-1 and a function relationship between the input and output terminals TFCPI21, TFCPO21 of the function generator 17-2 are set to be both substantially "1" in absolute value, namely, a linear relationship and opposite to each other in change direction, namely, opposite in sign. In the case of this configuration setting, there is a twofold sensitivity relationship with the control phase quantity ($\phi2 - \phi1$).

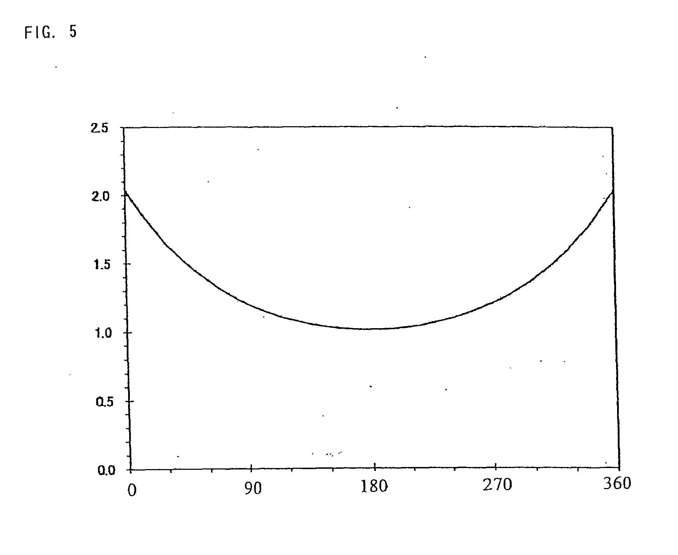

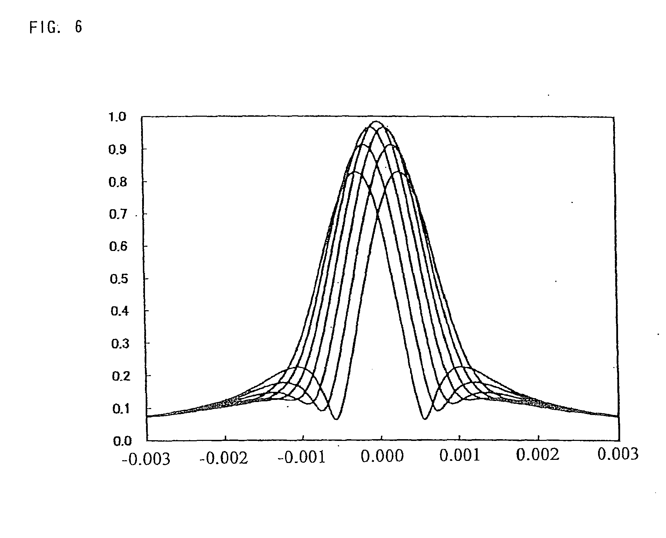

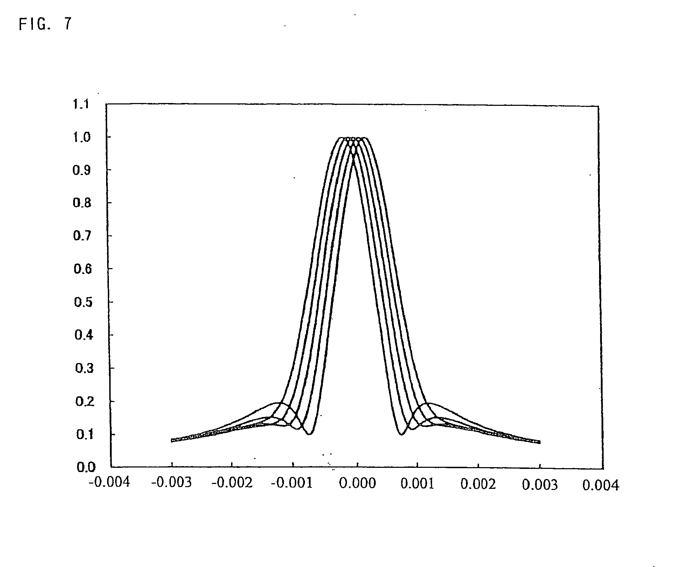

As to the two output adjustment signal input terminal TFCAI11, TFCAI21, function relationships between input and output that are a function relationship between the input and output terminals TFCA111, TFCAO11 of the function generator 17-3 and a function relationship between the input and output terminals TFCAI21, TFCA021 of the function generator 17-4 are set to be a function relationship shaped like a downward-convex quadratic curve with a minimum point in the center of a variable range as shown in FIG. 5. This curve is a function relationship representing such a compensation curve that with the control phase quantity being set at that point, the peak value of resonance curves is constant, and is uniquely determined. Thus, when the control phase quantity is varied, instead of varying like curves of FIG. 6, the peak output is kept constant as shown in FIG. 7. That is, the constancy of the peak output is satisfied. The output adjustment circuit may be a variable attenuator having constant output impedance or a combined circuit of a resistance voltage dividing circuit having a variable voltage dividing ratio and a buffer amplifying circuit, and that variableness may be continuous variableness or stepwise variableness.

The operation of the composite resonance circuit of Embodiment 2 will be described. First, the input signal of a frequency f is applied to the input terminal 3. The first and second phase control circuits 4, 5 shift the phase of the input signal by $\phi1$ and $\phi2$ respectively according to the phase control signals from the function transformers 17-1 and 17-2. The first and second output adjustment circuits 22, 23 adjust their own gains according to the gain control signals from the respective function transformers 17-3 and 17-4 to adjust the output power of the signals having their phases shifted by $\phi1$ and $\phi2$ and output the signals having their phases shifted by $\phi1$ and $\phi2$ with their output power adjusted to the resonance circuit 6. Thus, the signals having their phases shifted by $\phi1$ and $\phi2$ with respect to the input signal are supplied to the resonance circuit 6.

With the composite resonance circuit of Embodiment 2, the gains of the first and second relay circuits 22, 23 can be adjusted according to the gain control signals in association with the control phase quantity ($\phi2 - \phi1$) without changing the physical constants such as immittance frequencies of the resonance elements in the resonance circuit 6. Thus, as compared with Embodiment 1, the resonance frequency range, resonance sharpness, and the like of the resonance output of the resonance circuit 6 can be more finely adjusted.

Although in Embodiment 2 description has been made in which the gains of the first and second output adjustment circuits 22, 23 as the first and second relay circuits are variable according to the gain control signals, as long as the gains can be set to be optimal, they need not be variable. Namely, the first and second relay circuits of Embodiment 2 may be relay circuits having fixed gains and output impedances, or relay circuits whose gains and output impedances are adjustable manually independently of each other as long as the composite resonance circuit of Embodiment 2 has a frequency range and resonance sharpness corresponding to its use.

Embodiment 3

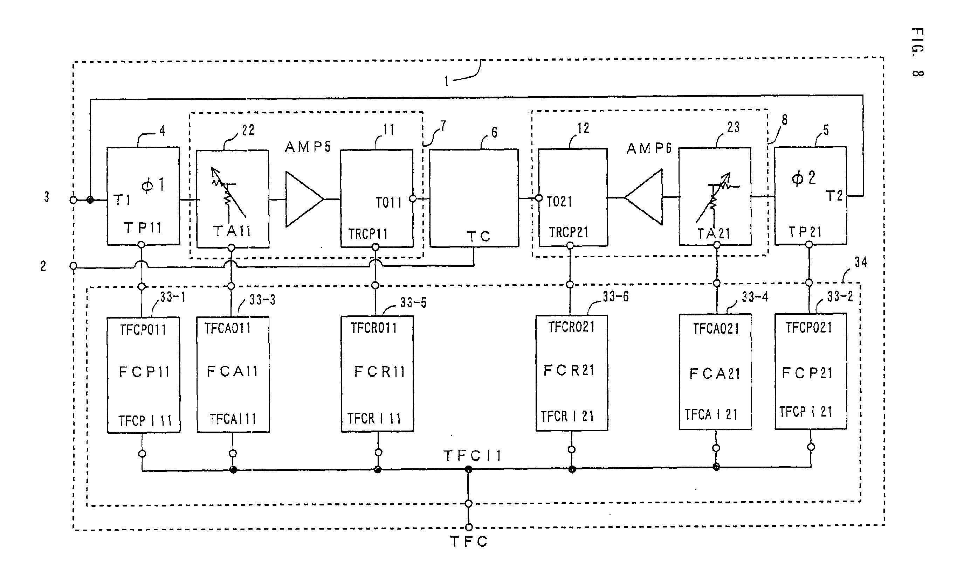

FIG. 8 shows Embodiment 3 according to a composite resonance circuit of the present invention. As shown in FIG. 8, a composite resonance circuit 1 comprises an input terminal 3, a resonance circuit 6 having a first port terminal TR11 and a second port terminal TR21, and first and second phase control circuits 4 and 5 performing different phase shifts $\phi1$ and $\phi2$ on an input signal supplied to the input terminal 3 to supply the phase-shifted signals to the first port terminal TR11 and the second port terminal TR21 of the resonance circuit 6 respectively. First and second relay circuits 7, 8 are connected respectively between the first phase control circuit 4 and the first port terminal TR11 and between the second phase control circuit 5 and the second port terminal TR21 to relay the shifted signal outputs of the first and second phase control circuits 4 and 5 to the resonance circuit 6. The respective output impedances and gains of the first and second relay circuits 7, 8 are variable independently of each other. The output impedances and gains are variable according to control signals independently of each other. The first relay circuit 7 comprises a variable attenuation amplifying circuit 22 whose gain varies according to the control signal and a variable impedance circuit 11 serially connected to the variable attenuation amplifying circuit 22 via a buffer amplifier AMP5 and whose output impedance varies according to the control signal. Note that in Embodiment 3 description will be made referring to the variable attenuation amplifying circuit 22 as the first output adjustment circuit 22 and the variable impedance circuit 11 as the first internal resistance variable drive circuit 11. The second relay circuit comprises a variable attenuation amplifying circuit 23 whose gain varies according to the control signal and a variable impedance circuit 12 serially connected to the variable attenuation amplifying circuit 23 via a buffer amplifier AMP6 and whose output impedance varies according to the control signal. Note that in Embodiment 3 description will be made referring to the variable attenuation amplifying circuit 23 as the second output adjustment circuit 23 and the variable impedance circuit 12 as the second internal resistance variable drive circuit 12. The first and second phase control circuits 4 and 5 perform different phase shifts $\phi 1$ and $\phi 2$ according to control signals respectively.

The components of the composite resonance circuit 1 shown in FIG. 8 will be further described in detail. The input terminal 3 of the composite resonance circuit 1 of FIG. 8 is connected to the same standard signal generator SG (not shown) as in FIG. 1, and an input signal having its output power maintained constant and its frequency f swept continuously is applied to the input terminal 3 of the composite resonance circuit 1 of FIG. 8. The input signal is supplied to each of an input terminal T1 of the first phase control circuit 4 and an input terminal T2 of the second phase control circuit 5.

The first phase control circuit 4 has the input terminal T1, a phase control signal input terminal TP11, and an output terminal. The input terminal T1 is connected to the input terminal 3; the output terminal is connected to an input terminal of the first output adjustment circuit 22; and the phase control signal input terminal TP11 is connected to a phase control signal output terminal TFCPO11 of a function transformer 33-1 of a function transformer group 34.

The first phase control circuit 4 has the input signal inputted thereto via the input terminal T1 and has a phase control signal from the function transformer 33-1 of the function transformer group 34 inputted thereto via the phase control signal input terminal TP11. Further, the first phase control circuit 4, in response to the phase control signal from the function transformer 33-1 of the function transformer group 34, shifts the phase of the input signal applied to the input terminal T1 by $\phi 1$. Further, the first phase control circuit 4 outputs the signal having its phase shifted by $\phi 1$ via the output terminal to the first output adjustment circuit 22.

The second phase control circuit 5 has the input terminal T2, a phase control signal input terminal TP21, and an output terminal. The input terminal T2 is connected to the input terminal 3; the output terminal is connected to an input terminal of the second output adjustment circuit 23; and the phase control signal input terminal TP21 is connected to a phase control signal output terminal TFCP021 of a function transformer 33-2 of the function transformer group 34.

The second phase control circuit 5 has the input signal inputted thereto via the input terminal T2 and has a phase control signal from the function transformer 33-2 of the function transformer group 34 inputted thereto via the phase control signal input terminal TP21. Further, the second phase control circuit 5, in response to the phase control signal from the function transformer 33-2 of the function transformer group 34, shifts the phase of the input signal applied to the input terminal T2 by $\phi 2$. Further, the second phase control circuit 5 outputs the signal having its phase shifted by $\phi 2$ via the output terminal to the second output adjustment circuit 23.

In variants of the first and second phase control circuits 4, 5, the phases $\phi 1$ and $\phi 2$ by which the first and second phase control circuits 4, 5 shift respectively may be variable continuously or stepwise according to the phase control signals, or may have preset, fixed values, or may be variable continuously or stepwise manually.

The first output adjustment circuit 22 has an input terminal, a first output adjustment signal input terminal TA11, and an output terminal. The input terminal of the first output adjustment circuit 22 is connected to the output terminal of the first phase control circuit 4. The output terminal of the first output adjustment circuit 22 is connected to the input terminal of the amplifier AMP5. The first output adjustment signal input terminal TA11 is connected to a phase control signal output terminal TFCAO11 of a function transformer 33-3 of the function transformer group 34.

The signal having its phase shifted by $\phi 1$ is input to the first output adjustment circuit 22 via its input terminal. Further, a gain control signal from the function transformer 33-3 of the function transformer group 34 is input to the first output adjustment circuit 22 via the first output adjustment signal input terminal TA11. Further, the first output adjustment circuit 22, in response to the gain control signal from the function transformer 33-3 of the function transformer group 34, adjusts its own gain, thereby adjusting the output power of the signal having its phase shifted by $\phi 1$ and outputs the signal having its phase shifted by $\phi 1$ with its output power adjusted via the output terminal to the amplifier AMP5.

The second output adjustment circuit 23 has an input terminal, a second output adjustment signal input terminal TA21, and an output terminal. The input terminal of the second output adjustment circuit 23 is connected to the output terminal of the second phase control circuit 5. The output terminal of the second output adjustment circuit 23 is connected to the input terminal of the amplifier AMP6. The second output adjustment signal input terminal TA21 is connected to a phase control signal output terminal TFCA021 of a function transformer 33-4 of the function transformer group 34.

The signal having its phase shifted by $\phi 2$ is input to the second output adjustment circuit 23 via its input terminal. Further, a gain control signal from the function transformer 33-4 of the function transformer group 34 is input to the second output adjustment circuit 23 via the second output adjustment signal input terminal TA21. Further, the second output adjustment circuit 23, in response to the gain control signal from the function transformer 33-4 of the function transformer group 34, adjusts its own gain, thereby adjusting the output power of the signal having its phase shifted by $\phi 2$ and outputs the signal having its phase shifted by $\phi 2$ with its output power adjusted via the output terminal to the amplifier AMP6.

In variants of the first and second output adjustment circuits 22, 23, the gain of the first and second output adjustment circuit 22, 23 may be variable continuously or stepwise according to the gain control signal, or may have a preset, fixed value, or may be variable continuously or stepwise manually.

Next, the AMP5 and AMP6 will be described. The AMP5 and AMP6 each have an input terminal and an output terminal. The input terminals are connected to the output terminals of the first and second output adjustment circuits 22 and 23 respectively. The output terminals are connected to the first and second internal resistance variable drive circuits 11 and 12 respectively. The AMP5 and AMP6 amplify the signals having their phases shifted by $\phi 1$ and $\phi 2$ from the first and second output adjustment circuits 22 and 23 with desired amplifications respectively.

Next, the first and second internal resistance variable drive circuits 11 and 12 will be described. Because the first and second internal resistance variable drive circuits 11 and 12 in the composite resonance circuit of Embodiment 3 are similar to those in FIGS. 1 and 2, only the differences will be described.

The first internal resistance variable drive circuit 11 has an internal resistance control terminal TRCP11 and adjusts its own output impedance in response to an impedance control signal from the function transformer 33-5 of the function transformer group 34 and outputs the signal having its phase shifted by $\phi 1$ with its output power maintained to the first port terminal TR11 of the resonance circuit 6.

The second internal resistance variable drive circuit 12 has an internal resistance control terminal TRCP21 and adjusts its own output impedance in response to an impedance control signal from the function transformer 33-6 of the function transformer group 34 and outputs the signal having its phase shifted by $\phi 2$ with its output power maintained to the second port terminal TR21 of the resonance circuit 6.

Note that the difference in phase between the input signal at the drive output terminal TO11 of the first internal resistance variable drive circuit 11 and the input signal at the drive output terminal T021 of the second internal resistance variable drive circuit 12 is a control phase quantity ($\phi 2 - \phi 1$). Internal voltages e1 and e2 of the drive circuits as viewed respectively from the drive output terminal TO11 of the first internal resistance variable drive circuit 11 and from the drive output terminal T021 of the second internal resistance variable drive circuit 12 are variable continuously or stepwise within a desired range without extremely fluctuating, and can be varied by varying the values of their internal resistances R1 and R2, that is, the values of internal resistance control quantities TRCP11 and TRCP21. The circuit configuration of the first and second internal resistance variable drive circuits 11 and 12 is the same as in FIG. 2, and hence description thereof is omitted.

The resonance circuit 6 has the same configuration as in, e.g., FIG. 1, and hence description thereof is omitted.

Next, the function transformer group 34 will be described. The function transformer group 34 has the function transformers 33-1, 33-2, 33-3, 33-4, 33-5, 33-6 and a phase control signal input terminal TFCI1. The function transformers 33-1 and 33-2 generate the phase control signals according to a frequency control signal; the function transformers 33-3 and 33-4 generate the gain control signals according to the frequency control signal; and the function transformers 33-5 and 33-6 generate the impedance control signals according to the frequency control signal.

The function transformer 33-1 has an input terminal TFCPI11 and an output terminal TFCP011. The input terminal TFCPI11 is connected to the phase control signal input terminal TFCI1 of the function transformer group 34, and the output terminal TFCPO11 is connected to the TP11 of the first phase control circuit 4. The function transformer 33-1 has the frequency control signal inputted thereto via the input terminal TFCPI11 and generates a phase control signal according to the frequency control signal and outputs the generated phase control signal via the output terminal TFCPO11 to the phase control signal input terminal TP11 of the first phase control circuit 4.

The function transformer 33-2 has an input terminal TFCPI21 and an output terminal TFCP021. The input terminal TFCPI21 is connected to the phase control signal input terminal TFCI1 of the function transformer group 34, and the output terminal TFCPO21 is connected to the TP21 of the second phase control circuit 5. The function transformer 33-2 has the frequency control signal inputted thereto via the input terminal TFCPI21 and generates a phase control signal according to the frequency control signal and outputs the generated phase control signal via the output terminal TFCPO21 to the phase control signal input terminal TP21 of the second phase control circuit 5.

The function transformer 33-3 has an input terminal TFCAI11 and an output terminal TFCAO11. The input terminal TFCAI11 is connected to the phase control signal input terminal TFCI1 of the function transformer group 34, and the output terminal TFCAO11 is connected to the TA11 of the first output adjustment circuit 22. The function transformer 33-3 has the frequency control signal inputted thereto via the input terminal TFCAI11 and generates a gain control signal according to the frequency control signal and outputs the generated gain control signal via the output terminal TFCAO11 to the TA11 of the first output adjustment circuit 22.

The function transformer 33-4 has an input terminal TFCAI21 and an output terminal TFCA021. The input terminal TFCAI21 is connected to the phase control signal input terminal TFCT1 of the function transformer group 34, and the output terminal TFCA021 is connected to the TA21 of the second output adjustment circuit 23. The function transformer 33-4 has the frequency control signal inputted thereto via the input terminal TFCAI21 and generates a gain control signal according to the frequency control signal and outputs the generated gain control signal via the output terminal TFCA021 to the TA21 of the second output adjustment circuit 23.

The function transformer 33-5 has an input terminal TFCRI11 and an output terminal TFCRO11. The input terminal TFCRI11 is connected to the phase control signal input terminal TFCI1 of the function transformer group 34, and the output terminal TFCRO11 is connected to the internal resistance control terminal TRCP11 of the first internal resistance variable drive circuit 11. The function transformer 33-5 has the frequency control signal inputted thereto via the input terminal TFCRI11 and generates an impedance control signal according to the frequency control signal and outputs the generated impedance control signal via the output terminal TFCRO11 to the internal resistance control terminal TRCP11 of the first internal resistance variable drive circuit 11.

The function transformer 33-6 has an input terminal, TFCRI21 and an output terminal TFCR021. The input terminal TFCRI21 is connected to the phase control signal input terminal TFCI1 of the function transformer group 34, and the output terminal TFCRO21 is connected to the internal resistance control terminal TRCP21 of the second internal resistance variable drive circuit 12. The function transformer 33-6 has the frequency control signal inputted thereto via the input terminal TFCRI21 and generates an impedance control signal according to the frequency control signal and outputs the generated impedance control signal via the output terminal TFCRO21 to the internal resistance control terminal TRCP21 of the second internal resistance variable drive circuit 12.

The operation of the composite resonance circuit of Embodiment 3 will be described. First, the input signal of a frequency f is applied to the input terminal 3. The first and second phase control circuits 4, 5 shift the phase of the input signal by $\phi1$ and $\phi2$ according to the phase control signals from the function transformers 33-1 and 33-2 respectively. The first and second output adjustment circuits 22, 23 adjust their own gains according to the gain control signals from the respective function transformers 33-3 and 33-4 to adjust the output power of the signals having their phases shifted by $\phi1$ and $\phi2$. The AMP5 and AMP6 amplify with a predetermined gain the signals having their phases shifted by $\phi1$ and $\phi2$ with their output power adjusted. The first and second internal resistance variable drive circuits 11 and 12 adjust their own output impedances to output the signals amplified with the predetermined gain to the resonance circuit 6. Thus, the signals having their phases shifted by $\phi1$ and $\phi2$ with respect to the input signal are supplied to the resonance circuit 6. The control phase quantity ($\phi2 - \phi1$) can be adjusted according to the frequency control signal inputted to the function transformer group 34 in association with the gain adjustment of the first and second output adjustment circuits 22, 23 and the output impedances of the first and second internal resistance variable drive circuits 11 and 12.

With the composite resonance circuit of Embodiment 3, the gains and output impedances of the first and second relay circuits 22, 23 can be adjusted according to the control signals in association with the control phase quantity ($\phi2 - \phi1$) without changing the physical constants such as immittance frequencies of the resonance elements in the resonance circuit 6. Thus, as compared with Embodiments 1 and 2, the resonance frequency range, resonance sharpness, and the like of the resonance output of the resonance circuit 6 can be more finely adjusted.

Although in Embodiment 3 description has been made in which the output impedances and gains of the first and second relay circuits 7, 8 are variable according to the control signals, they need not be variable as long as the relay circuits have optimum output impedances and gains. Namely, the first and second relay circuits of Embodiment 3 may be relay circuits having fixed gains and output impedances, or relay circuits whose gains and output impedances are adjustable manually independently of each other as long as the composite resonance circuit of Embodiment 3 has a frequency range and resonance sharpness corresponding to its use.

Description has been made in which the first and second relay circuits 7, 8 comprise respectively the first and second output adjustment circuits 22, 23 as the variable attenuation amplifying circuits 22, 23 and the first and second internal resistance variable drive circuits 11, 12 as the variable impedance circuits 11, 12. The first and second relay circuits 7, 8 may each comprise either a variable attenuation amplifying circuit or a. variable impedance circuit.

The fundamental effects of the present invention are summarized below.

It has been made clear that the parameters such as the internal resistances and gains of the relay circuits connected to the resonance unit play an important role in determining the output characteristics of the resonance unit. With the linearity being good and the resonance sharpness Q-factor being kept within a desired range, the peak frequency of the resonance characteristic curve of the resonance unit can be changed by changing other external parameters than the parameters of the resonance unit, without changing the resonance element constants of the resonance unit. By varying the parameters such as the internal resistances and gains of the relay circuits connected to the resonance unit in association with the control phase quantity, the composite resonance circuit which satisfies the linearity of frequency variation and the constancy of the resonance sharpness simultaneously is obtained. By varying the output power of the peripheral circuits of the resonance unit in association with the control phase quantity, the composite resonance circuit which satisfies either the linearity of frequency variation or the constancy of the resonance sharpness and the constancy of the peak output of the absolute value of the current flowing into the resonance unit simultaneously is obtained.

The composite resonance circuit of the present invention has the first and second phase shift circuits and the resonance unit, and further has the first and second relay circuits. By selecting a relay circuit having circuit constants, such as gain and output impedance, optimal for its use from several kinds of relay circuits that are built in beforehand for characteristics of a combined circuit of the resonance unit and phase shifts, the resonance frequency variable range can be set with greater degrees of freedom so as to cover a wide frequency range, without changing physical constants such as the resonance frequency of each resonance element in the resonance unit and without degrading the effective resonance sharpness Q-factor.

Further, in the composite resonance circuit of the present invention, the respective output impedances and gains of the first and second relay circuits are variable independently of each other. By changing both or one of the output impedance and gain, the resonance frequency range, resonance sharpness, linear frequency responsiveness, constancy, and the like of the resonance output of the resonance unit itself can be finely adjusted freely. Thus, for example, in the case where at shipment variation in resonance sharpness between the products is suppressed, thereby setting the Q-factor to be within a predetermined range, the output impedances and gains need only be finely adjusted independently of each other such that the Q-factor of the resonance output of the resonance unit is within a predetermined range.

In the composite resonance circuit of the present invention, by changing the control phase quantity ($\phi2 - \phi1$) in association with the output impedances and/or gains of the relay circuits, the resonance frequency range, resonance sharpness, linear frequency responsiveness, constancy, and the like of the resonance output of the resonance unit itself can be further finely adjusted.

Although in the composite resonance circuits of the embodiments 1 to 3 the resonance unit according to the present invention is a resonance circuit comprising two-terminal circuits having inductive reactance (a coil element) and capacitive reactance (a capacitor element), the present invention is not limited to these.

Although in the composite resonance circuits of the embodiments 1 to 3 the first and second phase shift circuits according to the present invention are the first and second phase control circuits shifting the phase of the input signal by $\phi1$ and $\phi2$, the present invention is not limited to these. For example, the first and second phase control circuits may shift the phase of the input signal not only into a single phase but also into multiple phases.

### Claims

1. A composite resonance circuit comprising:

   an input terminal;
   a resonance unit having first and second input ports; and
   first and second phase shift circuits that perform different phase shifts on an input signal supplied to said input terminal and supply the phase-shifted signals respectively to said first and second input ports of said resonance unit,
   wherein first and second relay circuits are respectively connected between said first phase shift circuit and said first input port and between said second phase shift circuit and said second input port to relay shift outputs of said first and second phase shift circuits to said resonance unit.

2. A composite resonance circuit according to claim 1, wherein respective output impedances and gains of said first and second relay circuits are variable independently of each other.

3. A composite resonance circuit according to claim 2, wherein said output impedances and gains are variable independently of each other according to control signals.

4. A composite resonance circuit according to claim 3, wherein each of said first and second relay circuits is constituted by a variable attenuation amplifying circuit whose gain is variable according to said control signal.

5. A composite resonance circuit according to claim 3, wherein each of said first and second relay circuits is constituted by a variable impedance circuit whose output impedance is variable according to said control signal.

6. A composite resonance circuit according to claim 3, wherein each of said first and second relay circuits comprises:

   a variable attenuation amplifying circuit whose gain is variable according to said control signal; and
   a variable impedance circuit serially connected to said variable attenuation amplifying circuit via a buffer amplifier
   and whose output impedance is variable according to said control signal.

7. A composite resonance circuit according to claim 3, wherein said first and second phase shift circuits perform different phase shifts according to said control signals.

FIG. 1

FIG. 2

EP 2 421 152 A1

17

FIG. 3

FIG. 4

FIG. 5

FIG. 6

FIG. 7

FIG. 8

<table>
<tr><td colspan="2" align="center">**INTERNATIONAL SEARCH REPORT**</td><td colspan="2">International application No.<br>PCT/JP2010/051477</td></tr>
</table>

A.    CLASSIFICATION OF SUBJECT MATTER
*H03H11/04*(2006.01)i, *H03H7/12*(2006.01)i, *H03H11/20*(2006.01)i

According to International Patent Classification (IPC) or to both national classification and IPC

B.    FIELDS SEARCHED

Minimum documentation searched (classification system followed by classification symbols)
HH03H11/00-H03H11/54, H03H1/00-H03H3/00, H03H5/00-H03H7/13

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| A | JP 10-256809 A  (Matsushita Electric Industrial Co., Ltd.), 25 September 1998 (25.09.1998), paragraphs [0018] to [0019]; fig. 1 (Family: none) | 1-7 |
| A | WO 2008/066552 A1  (ZYION, INC.), 05 June 2008 (05.06.2008), fig. 1 to 2; pages 8 to 13 & US 2008/0252366 A1    & EP 2097976 A & JP 2010-512045 A | 1-7 |
| A | JP 7-321586 A  (Kokusai Electric Co., Ltd.), 08 December 1995 (08.12.1995), fig. 2 (Family: none) | 1-7 |

☐    Further documents are listed in the continuation of Box C.          ☐    See patent family annex.

| | |
|---|---|
| \*     Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search<br>19 April, 2010 (19.04.10) | Date of mailing of the international search report<br>11 May, 2010 (11.05.10) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2006319115 A